(19) Europäisches Patentamt
European Patent Office
Office européen des brevets

(11) **EP 3 018 484 A1**

(12) **EUROPEAN PATENT APPLICATION**

(43) Date of publication:
**11.05.2016 Bulletin 2016/19**

(51) Int Cl.:
*G01R 19/00* (2006.01)    *G01D 5/00* (2006.01)
*G01R 19/25* (2006.01)

(21) Application number: **15382518.7**

(22) Date of filing: **22.10.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **07.11.2014 ES 201431631**

(71) Applicant: **Seat, S.A.**
**08760 Martorell - Barcelona (ES)**

(72) Inventors:
• **Gaitán Pitre, Jorge Eliécer**
**08760 BARCELONA (ES)**
• **Pallàs Areny, Ramón**
**08760 BARCELONA (ES)**

(74) Representative: **Isern-Jara, Nuria**
**Avda. Diagonal 463 Bis 2°**
**08036 Barcelona (ES)**

(54) **DEVICE AND METHOD FOR MEASURING ELECTRICAL VARIABLES OF ANALOG SENSORS**

(57)    Device for measuring electrical variables of analog sensors wherein a controller 3 connected to a capacitance network (1) and to an interface circuit (2) connected to an analog sensor (21), and wherein said capacitance network (1): is connected to said interface circuit (2) connected to the analog sensor (21), comprises at least two electrical capacitors (11) of known value, wherein the relation of the capacitance between at least two of said electrical capacitors (11) is at least 10:1. Said device is applicable to the measurement of electrical voltages of analog sensors which are based on a change in capacitance, electrical resistance or inductance or which generate directly an electric current or a voltage. The invention also comprises the associated measurement method.

FIG. 3

**Description**

SUBJECT OF THE INVENTION

The subject of the present patent application is a device and method for measuring electrical variables of analog sensors according to Claims 1 and 11, incorporating significant innovations and advantages.

The present invention relates, in general, to systems for measuring analog sensors, including those which generate directly an electric current or voltage.

PRIOR ART

The output signal of analog sensors is usually a low-amplitude electrical voltage generated by the sensor or by an interface circuit which incorporates one or more sensors and, if necessary, one or more electric voltage or current sources. The methods proposed according to the present state of the art for measuring said output voltage or current of analog sensors or of its interface circuits are numerous and at present all strive to obtain a digital output which may be achieved directly or indirectly.

Obtaining directly a digital output from the voltage generated by the sensor, or by the interface circuit to which the sensor is connected in order to obtain an analog output voltage, is achieved by means of an analog-to-digital voltage converter (A/D converter or ADC), which may be a specific integrated circuit, or a circuit embedded in another multifunctional circuit, such as a digital controller. The output of said analog/digital converter is processed digitally in order to extract the desired information or in order to take a decision. In order to adapt the output signal of the sensor or of its interface circuit to the range of input amplitudes of the A/D converter, a signal conditioning circuit which includes at least one component capable of amplifying voltages or currents is added.

The interface circuits for resistive sensors are usually based on voltage dividers, for example when the change in resistance relative to its initial value is great, or on circuits derived from the voltage divider, for example when the change in resistance relative to its initial value is small. Wheatstone bridges and continuous pseudo-bridges, such as those described, for example, in the patent US3130578 and in the patent applications EP1397654 and US20130249574 may be regarded as interface circuits derived from the voltage divider.

The interface circuits for capacitive or inductive sensors may also be based on voltage dividers, or may consist of bridges supplied by an alternating voltage, or resonant circuits, such as those described for example in the patent US2932970 and in the patent application US20130271158. The resistive sensors may also be incorporated in resonant circuits.

The analog sensors based on a variation in resistance, capacitance or inductance may be of the simple or differential type. In the first case they take the form of a single electronic component which changes with the variable measured, whereas in the second case they take the form of two electronic components which have a common node and in which the variable measured causes a change of the same magnitude, but in the opposite direction.

In general, voltage dividers may include a simple sensor or a differential sensor, while (continuous or alternating) bridges may include one, two, three or four variable impedance sensors or various sensors which are connected in combinations in series and in parallel and which are arranged in one, two or three arms of the bridge. Voltage dividers have as a minimum three terminals for connection with the signal conditioning circuit which requires the A/D converter: an excitation voltage is applied between two terminals and the voltage is measured between the third terminal and one of the two prior terminals. Sensor bridges, instead, have a minimum of four terminals which are usually connected in pairs: via one pair the bridge is excited by means of a electric voltage or current, and via the other pair the output voltage or current is detected.

Thus, the conventional method for measuring analog sensors directly is to arrange them in a circuit which obtains an electric voltage related to the variable detected by the sensor and to digitalize said voltage with an analog/digital converter (ADC).

Alternatively, the sensors based on a variation in resistance or capacitance may be placed in a circuit which generates a signal, the duration of which depends on the value of the magnitude detected by the sensor. In order to obtain a digital output it is sufficient to measure therefore the duration of that signal for which a clock signal is required, it being then a more economical process than an analog/digital converter (ADC).

The manufacturers of automotive components offer integrated solutions for measuring physical and chemical parameters which include a sensor element and the electronic circuits necessary for offering a standardized electrical output (e.g. for a CAN bus). If the electrical output is not normalized, the sensor is connected to an associated control unit (ECUs, switch-boards) which usually accept various sensors. An example would be the electronic circuits which must be connected to a sensor element in order to measure the angle of the steering wheel. However, there exist at present in a motor vehicle many other sensors which could benefit from the development of the invention. Some of these could be:

1. Position and rotational angle sensors These are based on the change in electrical resistance of an angular or linear potentiometer and on the change in electrical resistance of a magneto-resistance. They are used to measure for example: the position of the accelerator pedal, the travel and position of the suspension, the position of the butterfly valves, and the position of the sensor plate in the injection system.

In the following patents it can be understood that many manufacturers continue proposing solutions based on the conventional structure involving conditioning and digitalization of the signal obtained by the sensor element: "US844125282. Rotational angle measurement apparatus", "DE102006032266A1. Sensor component", "DE60218016D1. Electrically assisted steering" and "DE102009032664A1. Motor vehicle accelerator pedal".

2. Absolute and differential pressure sensors These are based on changes in electric resistance due to a mechanical deformation. They are used to measure the pressure of: fuel, brake liquid, oil and coolant.

In the case of these sensors also, in the patents of various manufacturers the latter continue to proposes solutions based on the conventional measuring structure described above.

Furthermore, and depending on the desired precision and resolution, the signal conditioning circuits prior to the A/D converter and connected to the sensor interface circuit may require: voltage transformers: active components, such as operational or instrumentation amplifiers, and voltage comparators; complex manual or automatic adjustment systems.

These components and methods increase the cost of the final product up to a value which may be excessive for given applications or application areas.

In short, an analysis of the information existing hitherto shows that the current methods for measuring analog sensors are subject to some of the following drawbacks: (a) the need for an analog/digital converter and the (active) conditioning circuit in order to adapt the output voltage of the interface circuit or the sensor to the range of input amplitudes of the analog/digital converter; (b) the need for a digital counter and a clock signal, the frequency of which determines the resolution which will be obtained during measurement; and (c) the applicability limited to a type of sensor, for example for the transfer of charge to the capacitive sensors.

Thus there still exists the need for a device, and an associated method, for measuring analog sensors based on a change in capacitance, electrical resistance or inductance or which generate directly an electric current or voltage of the order of millivolts. This includes numerous sensors for temperature, lighting, position, proximity, displacement, force, pressure and other variables usually found in the automotive sector and in other industrial sectors.

DESCRIPTION OF THE INVENTION

In accordance with the present invention, this task is solved by means of a device and method for measuring electrical variables of analog sensors according to Claims 1 and 11. Additional advantages of the invention are described together with the characteristics contained in the dependent claims and mentioned in the description provided below.

The object of the present patent application is to provide a new method for measuring analog sensors which are based on a change in electrical resistance (resistive sensors), capacitance (capacitive sensors) or inductance (inductive sensors) or which generate directly an electric current or voltage (generators). A second object is to provide a device, based on said measurement method, using for this purpose: a network of capacitors of known value and switchable connections; a circuit which includes: at least one analog sensor and a passive interface circuit; and a digital controller.

The innovative solution proposed consists in that the object of the present invention may be achieved by using at least two electrical capacitors and a controller, without the need for any other active electronic component, apart from said controller.

Thus, and more specifically, the device for measuring electrical variables of analog sensors comprises a controller, preferably a digital controller, connected to a capacitance network and an interface circuit connected to an analog sensor, wherein said capacitance network: is connected to said interface circuit connected to the analog sensor, comprises at least two electrical capacitors of known value (or any other element with capacitive properties), wherein the relation of the capacitance between at least two of said electrical capacitors is at least 10:1.

In this way the connection of the interface circuit to the digital controller avoids the need for an external power supply source and enables the current required to charge at least a first electrical capacitor of the capacitance network to be obtained. On the other hand the interface circuit which is proposed uses fewer electronic component than the sensors currently available, with connection of the sensor element directly to the microcontroller, without the need for intermediate integrated circuits for processing and digitalization of the signal provided by the sensor element. Only a number of passive components (resistors, electrical capacitors, etc.) are required. This absence of active components and the smaller number of passive components needed result in a lower cost and a greater reliability.

According to another aspect of the invention, the interface circuit and/or the capacitance network and/or the controller comprise at least one connection pin, wherein the interface circuit comprises at least one passive analog circuit between the pin which connects said interface circuit with the capacitance network and at least one of the pins which connect said interface circuit to the controller. "Passive analog circuit" is understood as meaning a purely resistive circuit, in the manner of a voltage divider, but it may also be an RC, RL or R circuit in parallel with a photodiode. The sensor and the calibration components are in parallel with a resistor.

As a result, the at least one passive analog circuit is composed of a plurality of passive electronic components, whereby these may be resistive, capacitive or inductive components; or a combination of these, RC or RL, including optionally photodiodes. In this way different alternatives for implementing the circuit are provided, such as the possibility of carrying out the measurement of sensors with a different main electrical property, be it resistive, capacitive or inductive. Also it allows the measurement of light strengths and levels using a photodiode.

In an alternative embodiment of the invention, the interface circuit comprises a Wheatstone bridge in which at least one of the components of each one of the arms is the analog sensor, said Wheatstone bridge being connected to a plurality of passive electronic components. In this way an alternative configuration to the series/parallel arrangement of electrical components is provided, and the advantages of the Wheatstone bridge arrangement are exploited.

According to the operating principle of the device, the interface circuit is supplied via at least one of the input/output pins of said controller. In this way an additional and independent power supply source is not necessary and instead the outputs of the associated controller are used.

According to another aspect of the invention, the controller, which is preferably digital, comprises a memory with a plurality of codes which correspond to the different ranges of values of the variable measured. In this way measurement ranges are established and, by means of comparison, it is determined within which of them the measurement performed lies, thus defining the corresponding output information of the controller in a predetermined format and/or values.

On the other hand, the capacitance network comprises at least one connection switchable between at least two electrical capacitors with known values. It is thus possible to eliminate optionally from the circuit concrete components, by bridging them or else disconnecting them from the circuit leaving at least one of its terminals freely exposed.

It should be mentioned that, in a preferred embodiment of the invention, the relation of the capacitance between at least two of said electrical capacitors is at least 100:1. In this way it is possible to establish greater precision in the measurement since a greater number of charge redistribution cycles for the same measurement are required.

In another preferred embodiment of the invention, the relation of the capacitance between at least two of said electrical capacitors is at least 1,000:1. In this way it is possible to establish even greater precision in the measurement since a greater number of charge redistribution cycles are required for the same measurement.

In yet another preferred embodiment of the invention, the relation of the capacitance between at least two of said electrical capacitors is at least 10,000:1. In this way it is possible to establish an even greater precision in the measurement since a greater number of charge redistribution cycles are required for the same measurement.

It is also an object of the present patent application to provide a method for measuring electrical variables of analog sensors, which comprises the following steps:

a) generating a voltage by means of the analog sensor and/or the interface circuit which includes it;

b) charging with said voltage at least one first electrical capacitor of said capacitance network, by switching the connections between the controller, the capacitance network and the analog signal and/or the interface circuit.

c) redistributing the charge stored in said at least one first electrical capacitor in at least one second electrical capacitor of said capacitance network, by switching the connections between the controller and the capacitance network;

d) repeating the steps a), b) and c) until the voltage at the terminals of the at least one second electrical capacitor of the capacitance network reaches a predefined voltage threshold.

Said method does not require either an analog/digital converter (ADC), nor any time measurement device, but a simple event counter. It is based on the use of a capacitance network which comprises at least two electrical capacitors with known values, one of which is much greater than the other one. In order to measure the voltage generated by the circuit which incorporates the sensor, at least one of the two capacitors is charged with said voltage and the charge is then redistributed in them. The process is repeated until the voltage at the terminals of at least one of the capacitors reaches a predefined voltage threshold VT. The number N of repetitions of the charge redistribution process therefore depends on the relation between the capacitances of the two capacitors, the predefined threshold and the voltage of the circuit which incorporates the sensor. In order to increase the value of N and thus improve the resolution of the method, the charging time of the small capacitor may be limited so that said capacitor does not remain fully charged.

All the functions of switching the connections between capacitors, comparison with a voltage threshold, control of the charging time and counting of events may be performed using a simple low-cost microcontroller which provides a standard digital output.

Indirectly obtaining a digital output from the changes which the sensor undergoes depending on the variable detected consists in deducing the value of this variable using a model (e.g. a formula) which relates its value to that of another variable of a different kind, but which is not an electrical voltage or current and which is related to that variable of interest. This method is capable, therefore, of obtaining a digital output without the need for voltage digitalizing devices, namely, without an A/D converter.

The transfer of charge from one unknown capacitor (sensor) to another capacitor of known value is a habitual process for measuring capacitive sensors which are charged to a known voltage. The method described in this patent is different because: (a) it requires a capacitance network which comprises at least two capacitors of known value (or any other component with capacitive properties) such that the relation between its capacitances is known, while in the known charge transfer methods the capacitance of an unknown capacitor is determined; (b) the voltage Vx needed to charge the components of the capacitance network is not a known voltage (as in the known charge transfer methods) but it is generated by the sensor or by a circuit where the sensor is connected to passive components; and (c) the voltage which, when it reaches the value VT, causes termination of the process is not the voltage at the terminals of a specific capacitor, but it is obtained at the terminals of at least two capacitors of the capacitance network which depends on the structure of this network. As a result of these differences it is possible to obtain at least four advantages which are lacking in the known charge transfer methods used hitherto to measure capacitive sensors. (1) the method may be applied both to capacitive sensors, as well as to resistive sensors, inductive sensors or voltage or current generating sensors; (2) the resolution may be improved by controlling the time during which the voltage Vx is applied to one or more components of the capacitance network; (3) the resolution may be improved also by detecting the drop in voltage instead of the voltage increase, for example at the terminals of a capacitor; and (4) the detection of voltage at the terminals of at least two capacitors of the capacitance network may be performed at a low earth impedance node and thus reduce the effects of capacitive interferences.

Advantageously, the controller limits the charging time of the at least one first electrical capacitor of said capacitance network so that said at least one first electrical capacitor does not remain fully charged. In this way (limiting for example the charging time of the small capacitor) the value of N increases and thus improves the resolution of the method.

The operating principle of the method is based on the fact that the controller counts the number of cycles necessary for achieving a given voltage at the terminals of said at least one second electrical capacitor, by redistributing on successive occasions a specific quantity of charge of the at least one first electrical capacitor in said at least one second electrical capacitor. In this way it is possible to perform a measurement in such a simple way as that of counting a number of charging and discharging cycles.

According to another aspect of the invention the controller determines the measurement of the electrical variable of the analog sensor by comparing the number of times which the charge redistribution is repeated with a series of codes stored previously in a memory of said controller and corresponding to different ranges of values of the variable measured. In this way measurement ranges are established and, by means of comparison, it is determined within which of them the measurement performed lies, thus defining the corresponding output information of the controller in a predetermined format and/or values.

According to yet another aspect of the invention, the controller determines the measurement of the electrical variable by comparing the number of times which the charge redistribution is repeated with a series of codes stored previously in a memory of said controller and corresponding to a number of coefficients of a calibration curve of at least one passive electronic reference component. In this way, and by means of a simple calculation, the variable measured during processing of the measurement is obtained.

The attached drawings illustrate, by way of a non-limiting example, a device for measuring electrical variables of analog sensors, provided in accordance with the invention. Other characteristic features and advantages of said device and the associated method for measuring electrical variables of analog sensors, forming the subject of the present invention, will become clear from the description of a preferred, but not exclusive embodiment which is illustrated by way of a non-limiting example in the accompanying drawings in which:

BRIEF DESCRIPTION OF THE DRAWINGS

Figure 1 shows a block diagram of the device proposed, in accordance with the present invention;
Figure 2a shows a first possible embodiment of the capacitance network, in accordance with the present invention;
Figure 2b shows a second possible embodiment of the capacitance network, in accordance with the present invention;
Figure 2c shows a third possible embodiment of the capacitance network, in accordance with the present invention;
Figure 3 shows a preferred embodiment of the apparatus proposed in Figure 1, where the interface circuit comprises a simple resistive sensor Rx connected to other passive components, in accordance with the present invention;
Figure 4 shows a table which summarises the logic state of the pins of the controller during the sequence of operations for measuring Rx in the preferred embodiment of Figure 3, in accordance with the present invention;

Figure 5 shows a preferred embodiment of the device proposed in Figure 1, where the interface circuit comprises a simple capacitive sensor Cx connected to other passive components, in accordance with the present invention;

Figure 6 shows a table which summarises the logic state of the pins of the controller during the sequence of operations for measuring Cx in the preferred embodiment of Figure 5, in accordance with the present invention;

Figure 7 shows a preferred embodiment of the apparatus proposed in Figure 1, wherein the interface circuit comprises a simple inductive sensor Lx connected to other passive components, in accordance with the present invention;

Figure 8 shows a preferred embodiment of the apparatus proposed in Figure 1, wherein the interface circuit comprises four simple resistive sensors (R3, R4, R5 and R6) connected to form a Wheatstone bridge 23, in accordance with the present invention;

Figure 9 shows a preferred embodiment of the apparatus proposed in Figure 1, wherein the interface circuit comprises a photodiode (sensor) D connected to other passive components, in accordance with the present invention;

Figure 10 shows a table which summarises the logic state of the pins of the controller during the sequence of operations for measuring D in the preferred embodiment of Figure 9.

## DESCRIPTION OF A PREFERRED EMBODIMENT

In the light of the aforementioned figures and in accordance with the numbering adopted, said figures show a preferred example of embodiment of the invention which comprises the parts and elements which are indicated and described in detail below.

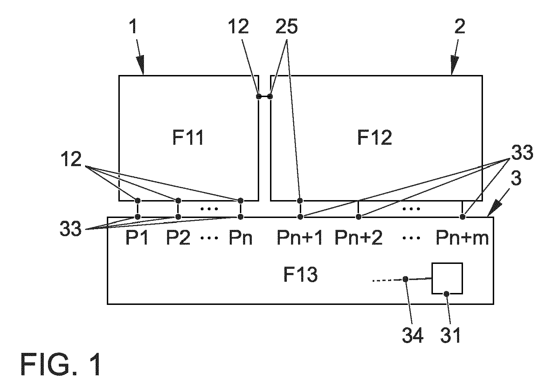

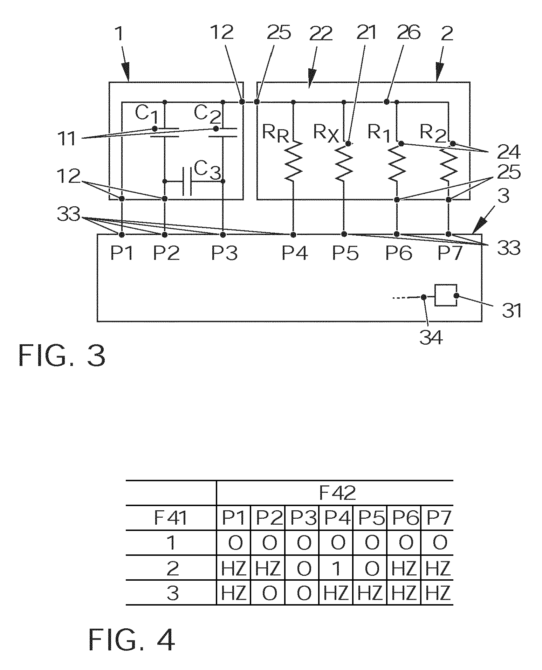

Thus, as can be seen in Figures 1 and 3, the device for measuring electrical variables of analog sensors which comprises a controller 3 connected to a capacitance network 1 and to an interface circuit 2 connected to an analog sensor 21, characterized in that said capacitance network 1: is connected to said interface circuit 2 connected to the analog sensor 21, comprises at least two electrical capacitors 11 of known value, wherein the relation of the capacitance between at least two of said electrical capacitors 11 is at least 10:1.

More specifically, the device conceived is based on a digital controller 3 which has, connected thereto, a capacitance network 1 and an interface circuit 2 which includes at least one analog sensor 21 connected, in each case, to passive components 24. Figure 1 is a block diagram of the measurement device proposed, where the capacitance network 1 comprises at least two capacitors 11 with known values (one of which much greater than the other ones) and switchable connections 13; the digital controller 3 has a finite number (m) of input/output pins (I/O) (P1,P2, ... Pn, Pn+1, Pn+2, ..., Pm) to which various nodes of the capacitance network 1 and the interface circuit 2 are connected. By means of the internal structure of the circuit connected to these I/O pins, three logic states may be determined: (a) output set to "0"; (b) output set to "1"; and (c) high input impedance state or input (HZ) which is the state adapted to the variable which is to be detected (voltage) and which may be enabled so that the measurement process is interrupted when a given voltage level is reached. The I/O voltage levels on each of these pins depends on the microelectronic technology used to manufacture the digital controller 3. Each one of these logic states is necessary in order for the digital controller 3 to perform a number of connection functions in the capacitance network 1 and the interface circuit 2, control of the charging time, counting of the charging cycles, and a comparison with a voltage threshold; all of this without the need for time or voltage measurement circuits incorporated in the digital controller 3 or outside of said digital controller 3. The digital controller 3 may be used moreover for other functions such as storage, display or communication of the measurement readings, combined or separately, with independence of the sensor or the component being measured.

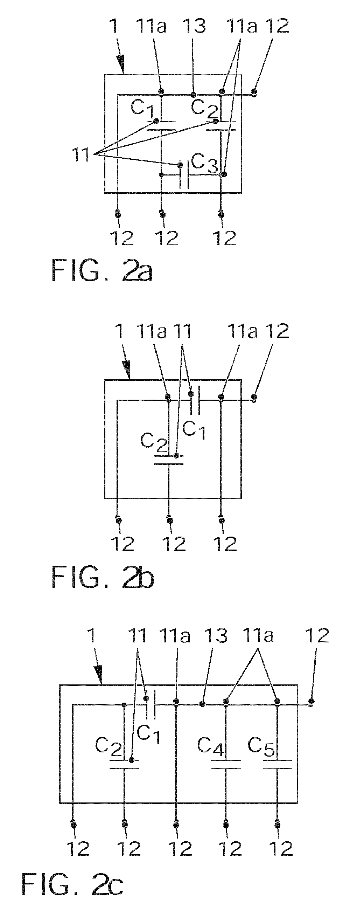

Figures 2a, 2b and 2c show three possible embodiments of the capacitance network 1, indicated hereinbelow as: network 1 (Figure 2a), network 2 (Figure 2b) and network 3 (Figure 2c) The network 1 consists of three capacitors C1, C2 and C3, with C1 and C2 connected in series, and C3 in parallel with the series connection of C1 and C2. The network 2 consists of two capacitors C1 and C2 connected in series. The network 3 consists of four capacitors C1, C2, C3 and C4 connected as follows: C1 and C2 connected in series with each other, C3 and C4 connected in parallel with each other and also in parallel with the series connection of C1 and C2. In each one of these embodiments: a) the capacitors have a relation of known value; b) C1 has a value much greater than the other capacitors; c) the node or pin 12 connects the capacitance network 1 to the interface circuit 2; d) the remaining nodes or pins 12, according to the embodiment, connect the capacitance network 1 to the digital controller 3; and e) the comparison with the predefined voltage threshold can be performed at the three first nodes or pins 12 on the left (P1-P3), which allows, firstly, the detection to be performed at a low impedance point and thus a reduction of the capacitive interference effects and, secondly, the voltage threshold margin to be greater if a voltage drop instead of a voltage increase is detected. These embodiments are simple examples for facilitating understanding of the patent of invention, but are not exhaustive as regards the detail of the circuits.

Additionally, as can be seen in Figures 3, 5, 7 and 9, the interface circuit 2 and/or the capacitance network 1 and/or the controller 3 comprise at least one pin 12, 25, 33 for connections 13, 26, 34 and where the interface circuit 2 comprises at least one passive analog circuit 22 between the pin 12, 25 which connects said interface circuit 2 to the capacitance network 1 and at least one of the pins 25, 33 which connect said interface circuit 2 to the controller 3. In a preferred embodiment of the invention, the controller 3 will have four pins 33 for connection to the interface circuit 2 and/or to the capacitance network 1.

It should be mentioned, as can be seen in Figures 3, 5, 7 and 9, that at least one passive analog circuit 22 is composed of a plurality of passive electronic components 24.

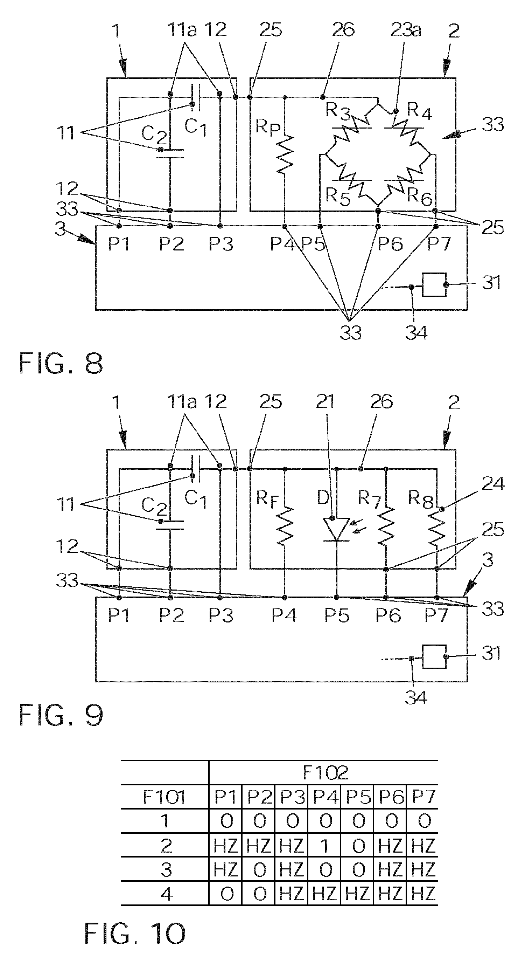

On the other hand, as can be seen in Figure 8, the interface circuit 2 comprises a Wheatstone bridge 23 in which at least one of the components 23a of each one of the arms is the analog sensor 21, said Wheatstone bridge 23 being connected to a plurality of passive electronic components 24.

According to another aspect of the invention, as can be seen in Figures 1, 3, 5, 7 and 9, the interface circuit 2 is supplied via at least one of the input/output pins 33 of said controller 3.

According to a preferred embodiment of the invention, as can be seen in Figures 1, 3, 5, 7 and 9, the controller 3 comprises a memory 31 with a plurality of codes 32 which correspond to the different ranges of values of the variable measured.

More particularly, as can be seen in Figures 2a, 2b and 2c, the capacitance network 1 comprises at least one connection 13 which can be switched between at least two electrical capacitors 11 with known values.

According to a preferred embodiment of the invention, the relation of the capacitance between at least two of said electrical capacitors 11 is at least 100:1.

According to another preferred embodiment of the invention, the relation of the capacitance between at least two of said electrical capacitors 11 is at least 1,000:1.

According to yet another preferred embodiment of the invention, the relation of the capacitance between at least two of said electrical capacitors 11 is at least 10,000:1.

It is also an object of the present patent application to provide a method for measuring electrical variables of analog sensors 21, which comprises the following steps:

   a) generating a voltage by means of the analog sensor 21 and/or the interface circuit 2 which includes it;
   b) charging with said voltage at least one first electrical capacitor 11 of said capacitance network 1, by switching the connections between the controller 3, the capacitance network 1 and the analog signal 21 and/or the interface circuit 2.
   c) redistributing the charge stored in said at least one first electrical capacitor 11 in at least one second electrical capacitor 11 of said capacitance network 1, by switching the connections between the controller 3 and the capacitance network 1;
   d) repeating the steps a), b) and c) until the voltage at the terminals 11a of the at least one second electrical capacitor 11 of the capacitance network 1 reaches a predefined voltage threshold.

Thus, said method consists in counting the number of cycles necessary for achieving a given voltage VT in a capacitance network 1 by redistributing (on successive occasions) a specific quantity of charge between its components; which charge is obtained by connecting one or more of these components, during a programmable time period, to a unknown voltage Vx which is generated by the interface circuit 2 which includes: 1) at least one analog sensor and 2) a passive interface circuit; both connected to the digital controller 3. The shorter said connection of Vx to the capacitance network 1, the less will be the charge stored in the components of said network, and the greater will be the number of times that the process will have to be repeated, thereby improving the resolution of the measurement. Said capacitance network 1 requires at least two capacitors 11 (or other component with capacitive properties), one of which must have a much greater capacitance than the others, and switchable connections. The number N of times that the charge redistribution process is repeated depends on the relation between the components of the capacitive network 1 and the voltage VT; consequently, in order to perform the switch-over of the analog sensor 21, it is sufficient to know the value of these parameters. The method may be implemented by means of a digital controller 3, without the need for any other active electronic component which is external or incorporated in its controller 3, such as an analog/digital converter or a circuit for measuring time by means of a clock signal and a voltage pulse counter.

The variable measured is determined by means of comparison of the number N of times that the charge redistribution process is repeated with a series of digital codes corresponding to different value ranges of the variable measured, said digital codes being provided in the form of a table. Another way of determining the variable measured is to measure one or more passive reference components in order to produce the coefficients of a calibration curve and obtain the variable measured by means of calculation. Said table and the coefficients of the calibration curve are stored in the memory 31 of the digital controller 3 so that they can be used during the measurement process.

The measurement method illustrated may be realized in different ways which involve a different number of components and interconnections in the capacitance network 1 and in the interface circuit 2. Whatever the form and the sequence of operations which the digital controller 3 performs, the method consists in at least three steps: a first step for zeroing any charge in the capacitance network 1; a second step for applying to the capacitance network 1 the voltage generated by the interface circuit 2 where the sensor 21 is located; and a third step for redistributing between one or more components of the capacitance network 1 the electrical charge applied during the previous step. Some of these sequences of operations are described at the end of the description, in the preferred embodiments of the measurement apparatus proposed.

It should be mentioned that the capacitance network is formed by at least two capacitances, one of which is much greater than the other ones. It should be pointed out, however, that the second step is not necessarily that for charging the smaller value of the capacitances, but one of these values. A voltage threshold may be detected on at least two different nodes or pins 12 of the capacitance network 1. Therefore, the voltage at the terminals of the capacitance of greatest value is not always measured.

By way of example, in Figure 2b, C1 is the greatest of the capacitances and is charged to the voltage between its terminals, which depends on the output voltage, the analog sensor 21 and/or the interface circuit 2 which includes it.

According to another aspect of the invention, the controller 3 limits the charging time of the at least one first electrical capacitor 11 of said capacitance network 1 so that said at least one first electrical capacitor 11 does not remain fully charged.

Thus the number N of repetitions of the charge redistribution process therefore depends on the relation between the capacitances of the two capacitors, the predefined threshold and the voltage of the circuit which incorporates the sensor 21. In order to increase the value of N and thus improve the resolution of the method, the charging time of the small capacitor may be limited so that it does not remain fully charged.

Below an example of a mathematical formula of said relation is provided, although there is no one single mathematical formula specifically designed for each one of the preferred embodiments proposed. Each equation depends on the components which form the interface circuit and the sensor 21. The equation which is shown is applicable for obtaining Nx in the circuit according to Figure 3.

$$Nx = \frac{\ln\left\{1 - VT \left/ \left[ VOH\dfrac{Rx}{Rx + R_R}\left(1 - e^{-T\frac{(Rx+R_R)(C1+C3)}{Rx\,R_R\left[C1(C2+C3)+C2C3\right]}}\right)\right]\right.\right\}}{\ln\left[\dfrac{C1^2}{(C1+C2)(C1+C3)}\right]}$$

where VOH is the output voltage of the fourth pin on the left of the controller 3 during the charging step, VT is the threshold voltage of the pin and T is the time for which the fourth pin maintains the voltage VOH.

More specifically, the controller 3 counts the number of cycles necessary for achieving a given voltage at the terminals 11 a of said at least one second electrical capacitor 11, by redistributing on successive occasions a specific quantity of charge of the at least one first electrical capacitor 11 in said at least one second electrical capacitor 11.

According to another aspect of the invention the controller 3 determines the measurement of the electrical variable of the analog sensor 21 by comparing the number of times which the charge redistribution is repeated, with a series of codes 32 stored previously in a memory 31 of said controller 3 and corresponding to different value ranges of the variable measured.

According to another aspect of the invention the controller 3 determines the measurement of the electrical variable by comparing the number of times which the charge redistribution is repeated, with a series of codes 32 stored previously in a memory 31 of said controller 3 and corresponding to coefficients of a calibration curve of at least one passive electronic reference component 24.

Below five preferred embodiments of the invention are described where: (a) the interface circuit 2 comprises at least one analog sensor 21 and a passive reference component; (b) the controller 3 is a very low-cost, common, 8-bit microcontroller which does not incorporate any analog/digital converter or other analog or digital peripheral circuits; (c) the pins 33 are I/O (input/output) pins of the controller 3, the internal structure of these I/O (input/output) pins 33 allowing three logic states to be established: (a) output set to "0", with an output voltage V0; (b) output set to "1", with an output voltage V1; and (c) input or HZ, which may be enabled in order to interrupt the measurement process when a given voltage is reached; (d) C1 and C2 are two electrical capacitors of known value, the relation of which is 10,000:1. In each one of these embodiments the controller 3 performs a sequence of operations in order to measure the sensor 21 or a reference component. Thus, therefore, there exist a number Ni of charging cycles for the sensor 21 or the measured reference component. Whence, using the equation which for each interface circuit 2 relates Vx to the value of the sensor 21, the value of the measured variable may be determined.

Figure 3 shows a first preferred embodiment of the apparatus according to Figure 1, where the capacitance network 1 is the network 1 and the interface circuit 2 comprises a simple resistive sensor Rx and a resistance of $R_R$ of known value which are arranged in a resistive voltage divider. R1 and R2 are two reference resistances, known and stable, necessary for calculating the coefficients of a calibration curve and obtaining Rx by means of calculation. C3 is a capacitor of known value, the relation of which to C1 is 100,000: 1. The sequence of operations which the controller 3 performs to measure both Rx and R1 and R2 consists of three steps: (1) zeroing, (2) charging, and (3) redistribution and reading. The specific set of operations for measuring Rx is as follows: Initially seven first pins 33 (P1-P7) of the controller 3 are configured as HZ so as to avoid, upon start-up of the system, that these pins 33 are configured in an undesirable manner. Thereafter, in step (1), seven first pins 33 (P1-P7) are configured as an output set to "0"; therefore, any electric charge stored in the components of the interface circuit 3 is drained to earth. Then, in step (2), the third and fifth pin 33 (P3, P5) remain in their prior state, while the fourth pin 33 (P4) is configured as an output set to "1" and the first, second, third, sixth and seventh pins 33 (P1, P2, P3, P6 and P7) are configured as HZ; consequently, C2 starts to charge and if the fourth pin 33 (P4) remains in the state "1" (voltage V1) for a sufficiently long period of time with respect to the resultant time constant Tc of the circuit RC, it will finally reach the voltage Vx of the voltage divider formed by Rx and $R_R$. If instead the fourth pin 33 (P4) remains in the state "1" for a shorter period of time, the voltage at the terminals of C2 will be a fraction of Vx so that the charge stored in it will be less. It should be noted that, with this arrangement of pins, both C3 is charged to the voltage V2 which is on the second pin 33, and C1 is charged to the voltage difference V12 at its terminals. Finally, in step (3), the first, third, sixth and seventh pins 33 (P1, P3, P6 and P7) remain in their prior state, the fourth and fifth pins 33 (P4 and P5) are configured as an input and the second pin 33 (P2) is configured as an output set "0". With this new arrangement of the pins 33, the charge stored in C2 is redistributed with C1, and the first pin 33 (P1) acts as a voltage comparator with TTL/CMOS threshold and high input impedance; the result is a voltage increase $\Delta VC1$ at the terminals of C1 proportional to the redistributed charge, and therefore to Vx, which in turn depends on Rx. Steps (2) and (3) are repeated until the voltage between the terminals of C1 is equal to or greater than the threshold voltage VT at the first pin 33 (P1). The control program counts the charge cycles necessary for reaching said threshold, without the need for any timer or voltage pulse counter integrated in the controller 3. At the end of the sequence, a number Nx of charging cycles related to the change in impedance of the sensor 21 is obtained. Nx will be all the greater, and therefore the measurement resolution will be all the better, the shorter the time period during which the fourth pin 33 (P4) remain in the state "1 ". An alternative to the above sequence of operations is to detect the drop in voltage $\Delta VC3$ at the terminals of C3 (on the second pin 33 (P2)), which depends on the charge which is stored in C1 during a previous measurement cycle. Thus, therefore, it is possible to detect a voltage threshold at at least two different nodes or pins 12 of the capacitance network 1.

Figure 4 is a table which summarises the logic state of the pins of the controller 3 during a cycle of the sequence for measuring Rx in the embodiment of Figure 3. The sequence of operations which the controller 3 performs to measure R1 and R2 is similar to that which is performed to measure Rx; the difference is that the sixth and seventh pins (P6 and P7) carry out, for each measurement, the function which the fifth pin (P5) carried out before, while the pins 33 which are not involved in the measurement are configured as HZ. Thus, therefore, the value Ni of charging cycles arising for each resistance measured is N1 and N2. Whence, using the equation which relates the voltage Vx of the interface circuit 2 to the value of Rx, it is possible to determine Rx with independence of VT and $R_R$. The changes in these components and parameters should not affect the measurement, instead the latter will depend on R1 ad R2 which must be sufficiently stable.

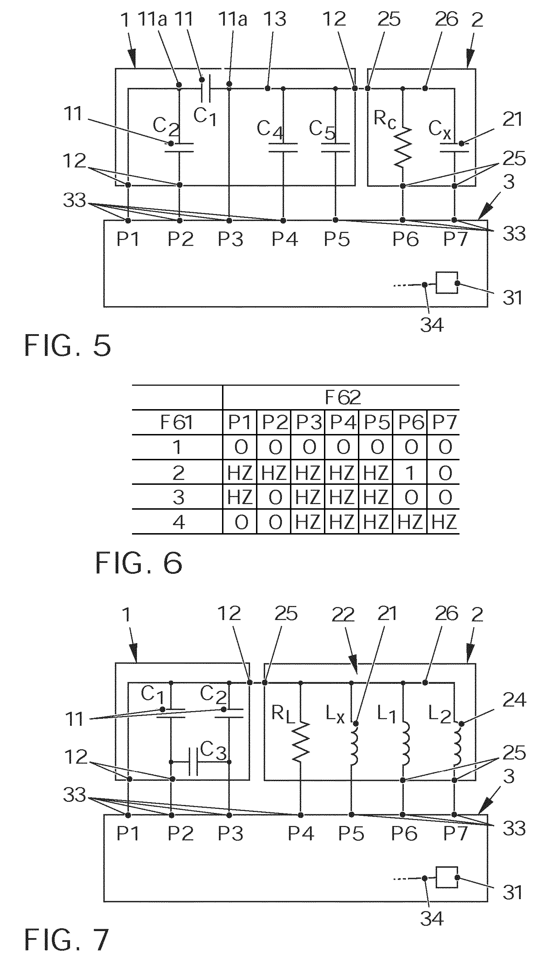

Figure 5 shows a second preferred embodiment of the apparatus according to Figure 1, where the capacitance network 1 is the network 3 and the interface circuit 2 comprises a simple capacitive sensor Cx and a resistance of $R_C$ of known value which are arranged in an RC circuit. C4 and C5 are two reference capacitors 11, the capacitances of which have a known and stable relation necessary for determining Cx. The sequence of operations which the controller 3 performs in order to measure both Cx and C4 and C5 consists of four steps: (1) zeroing, (2) charging, and (3) discharging/charging and reading, and (4) redistribution. The specific set of operations for measuring Cx is as follows: Initially, seven first pins 33 (P1-P7) are configured as HZ. Then, in step (1), seven first pins 33 (P1-P7) are configured as an output set to "0". Then, in step (2), P7 remains in its prior state, P6 is configured as an output set to "1", and P1 to P5 are configured as HZ; this arrangement of pins 33 is maintained for a sufficiently long time period compared to the time constant Tc of the circuit RC formed by Rc and Cx. Thus, therefore, Cx is charged via Rx to the voltage V1 of P6. It should be pointed out that this step of the measuring sequence is not to charge the capacitance network 1, but to apply a fixed change to the sensor 21. Thereafter, in step (3), P1, P3, P4, P5 and P7 remain at HZ, and P2 and P6 are configured as an output set to "0" (voltage V0); consequently, Cx is discharged to V0 and the network 3 is charged to a fraction of the discharge voltage Vx at the terminals of Cx. The duration of this pin arrangement must be sufficiently short compared to Tc and determines the resolution which will be obtained during the measurement. During this same step, the voltage level between the terminals of C2 will be detected and compared via P1. Finally, in step (4), P2, P3, P4 and P4 remain in their prior state, P1 is configured as an output set to "0", and P6 and P7 are configured as HZ. The steps (2), (3) and (4) are repeated until the voltage between the terminals of C2 is equal to or greater than the threshold voltage VT P1. At the end of the sequence, a number Nx of charging cycles related to the change in impedance of the sensor 21 is obtained. It should be noted that the voltage VT is achieved between the terminals of C2 during the discharging/charging step (3). However, it could also be achieved between the terminals C1 during the redistribution step (4). Figure 6 shows a table which summarises the logic state of the pins of the controller 3 during a cycle of the sequence of operations for measuring Cx in the embodiment in Figure 5.

The sequence of operations which the controller 3 performs to measure C3 and C4 is similar to that which is performed to measure Cx; the difference is that the pins 33 (P4 and P5) carry out, for each measurement, the function which the pin P7 carried out before, while the pins 33 which are not involved in the measurement are configured as HZ. Thus, therefore, the value Ni of charging cycles arising for each resistance measured is N3 and N4. Whence, using the equation which relates the voltage Vx of the interface circuit 2 to Cx, it is possible to determine Cx with independence of VT and Rc.

Figure 7 shows a third preferred embodiment of the apparatus according to Figure 1, where the capacitance network 1 is the network 1 and the interface circuit 2 comprises a simple inductive Lx sensor 21 and a known resistor RL, which are arranged in an RL circuit. L1 and L2 are two known and stable reference inductors necessary for determining Lx. The sequence of operations which the controller 3 performs to measure Lx, L1 and L2 is nearly the same as that which is used to measure Rx, R1 and R2, respectively, in the preferred embodiment of Figure 3. It differs in that the time which is applied to charge C2 to Vx is now determined for the time constant of the network RL.

Figure 8 shows a fourth preferred embodiment of the apparatus shown in Figure 1, where the capacitance network 1 is the network 2 and the interface circuit 2 comprises a maximum of four sensors 21 based on a change of resistance (R3, R4, R5 and R6) and connected so as to form a Wheatstone bridge 23, and a resistance $R_P$ of known value. The pin P1 is used as a measurement node. Let us assume that all the sensors 21 undergo the same relative change in resistance x, which may be positive or negative. The sequence of operations which the controller performs 3 to measure the change in relative x of each sensor 21 allows the interface circuit 2 to be analyzed as a set of voltage dividers formed, respectively, by Rp and the equivalent resistances Req1, Req2 and Req3 viewed, each one, from P5, P6 and P7 towards P1. Thus, therefore, x depends on the voltage drop in these voltage dividers. Following the same sequence of operations used to measure Rx described in the first embodiment, but using now a different charge path determined by the configuration of the three pins which connect the bridge to the controller 3, three different values of N are obtained. Whence, using the equation which describes the values of the equivalent resistances Req1, Req2 and Req3, it is possible to determine x with independence of VT and $R_P$.

Figure 9 shows a fifth preferred embodiment of the apparatus shown in Figure 1, where the capacitor network 1 is the network 2 and the interface circuit 2 comprises a photodiode D (sensor) and a known resistance $R_F$, with a common node 25. The equivalent electric circuit of the photodiode allows analysis of the circuit formed by D and RF as an RC circuit, the time constant of which depends on the intensity of the electromagnetic radiation striking the photodiode. R7 and R8 are two known resistances which are used to control the time constant and thus improve the resolution during measurement. The sequence of operations which the controller 3 performs in order to measure the variation in impedance which D undergoes is similar to that which the controller 3 performs in order to measure Cx in the preferred embodiment of Figure 5. The main differences are the pin arrangement 33 of the controller 3 and the time taken to charge C2 to Vx, which is now determined by the time constant of the circuit formed by D and $R_F$.

Figure 10 shows a table which summarises the logic state of the pins of the controller 3 during a cycle of the sequence for measuring D in the embodiment of Figure 9, when D is reverse polarized via $R_F$. The sequence of operations which the controller 3 performs to measure D when reverse polarization is performed via R7 and R8 is similar to that which is performed via $R_F$; the difference is that the pins P6 and P7 carry out, for each measurement, the function of the pin P4, while the pins 33 which are not involved in the measurement are configured as HZ. The variable measured is determined by means of comparison of the number N of times that the charge redistribution process is repeated with a series of digital codes corresponding to different value ranges of the variable measured, said digital codes being provided in the form of a table in the control program of the controller 3.

The above description of the preferred embodiments includes various specific details of the invention which may help understanding thereof, but is not exhaustive neither as regards the possible embodiments, nor as regards the detail of the circuit in which the sensor 21 is incorporated. Thus, the details, the forms, the dimensions and other accessories, as well as the components used in the implementation of said device, and associated method, for measuring electrical variables of analog sensors may be conveniently replaced by others which are technically equivalent and which do not depart from the essence of the invention nor the scope defined by the claims which are included following the list below.

List of reference numbers:

1      capacitance network
11    electrical capacitor

| 11a | terminal (of the electrical capacitor) |
|---|---|
| 12 | pin (capacitance network) |
| 13 | connection (capacitance network) |
| 2 | interface circuit |
| 21 | analog sensor |
| 22 | passive analog circuit |
| 23 | Wheatstone bridge |
| 23a | component (Wheatstone bridge) |
| 24 | passive electronic component |
| 25 | pin (interface circuit) |
| 26 | connection (interface circuit) |
| 3 | controller |
| 31 | memory |
| 32 | code |
| 33 | pin (controller) |
| 34 | connection (controller) |

**List of reference numbers used as abbreviations for the text within the figures**

| F11 | Capacitance network |
|---|---|
| F12 | Sensor and interface circuit |
| F13 | Digital controller |
| F41 | Step |
| F42 | Sequence for measuring Rx |
| F61 | Step |
| F62 | Sequence for measuring Cx |
| F101 | Step |
| F102 | Sequence for measuring D |

## Claims

1. Device for measuring electrical variables of analog sensors which comprises a controller (3), connected to a capacitance network (1), and to an interface circuit (2) connected to an analog sensor (21), **characterized in that** said capacitance network (1):

   - is connected to said interface circuit (2) connected to the analog sensor (21),
   - comprises at least two electrical capacitors (11) of known value,
   wherein the relation of the capacitance between at least two of said electrical capacitors (11) is at least 10:1.

2. Device according to Claim 1, **characterized in that** the interface circuit (2) and/or the capacitance network (1) and/or the controller (3) comprise at least one pin (12, 25, 33) for performing a connection (13, 26, 34) and wherein the interface circuit (2) comprises at least one passive analog circuit (22) between the pin (12, 25) which connects said interface circuit (2) to the capacitance network (1) and at least one of the pins (25, 33) which connect said interface circuit (2) to the controller (3).

3. Device according to Claim 2, **characterized in that** the at least one passive analog circuit (22) is composed of a plurality of passive electronic components (24).

4. Device according to Claim 1, **characterized in that** the interface circuit (2) comprises a Wheatstone bridge (23) in which at least one of the components (23a) of each one of the arms is the analog sensor (21), said Wheatstone bridge (23) being connected to a plurality of passive electronic components (24).

5. Device according to Claim 1, **characterized in that** the interface circuit (2) is supplied via at least one of the input/output pins (33) of said controller (3).

6. Device according to Claim 1, **characterized in that** the controller (3) comprises a memory (31) with a plurality of codes (32) which correspond to the different value ranges of the variable measured.

7. Device according to Claim 1, **characterized in that** the capacitance network (1) comprises at least one connection (13) which can be switched between at least two electrical capacitors (11) with known values.

8. Device according to Claim 1, **characterized in that** the relation of the capacitance between at least two of said electrical capacitors (11) is at least 100:1.

9. Device according to Claim 1, **characterized in that** the relation of the capacitance between at least two of said electrical capacitors (11) is at least equal to 1,000:1.

10. Device according to Claim 1, **characterized in that** the relation of the capacitance between at least two of said electrical capacitors (11) is at least 10,000:1.

11. Method for measuring electrical variables of analog sensors according to Claim 1, which comprises the following steps:

a) generating a voltage by means of the analog sensor (21) and/or the interface circuit (2) which includes it;
b) charging with said voltage at least one first electrical capacitor (11) of said capacitance network (1), by switching the connections between the controller (3), the capacitor network (1) and the analog signal (21) and/or the interface circuit (2);
c) redistributing the charge stored in said at least one first electrical capacitor (11) in at least one second electrical capacitor (11) of said capacitance network (1), by switching the connections between the controller (3) and the capacitor network (1);
d) repeating the steps a), b) and c) until the voltage at the terminals (11 a) of the at least one second electrical capacitor (11) of the capacitor network (1) reaches a predefined voltage threshold.

12. Method according to Claim 11, **characterized in that** the controller (3) limits the charging time of the at least one first electrical capacitor (11) of said capacitance network (1) so that said at least one first electrical capacitance (11) does not remain fully charged.

13. Method according to Claim 11, **characterized in that** the controller (3) counts the number of cycles necessary for achieving a given voltage at the terminals (11 a) of said at least one second electrical capacitor (11), by redistributing on successive occasions a specific quantity of charge of the at least one first electrical capacitor (11) in said at least one second electrical capacitor (11).

14. Method according to Claim 13, **characterized in that** the controller (3) determines the measurement of the electrical variable of the analog sensor (21) by comparing the number of times which the charge redistribution is repeated, with a series of codes (32) stored previously in a memory (31) of said controller (3) and corresponding to different ranges of values of the variable measured.

15. Method according to Claim 13, **characterized in that** the controller (3) determines the measurement of the electrical variable by comparing the number of times which the charge redistribution is repeated, with a series of codes (32) stored previously in a memory (31) of said controller (3) and corresponding to a number of coefficients of a calibration curve of at least one passive electronic reference component (24).

FIG. 1

FIG. 2a

FIG. 2b

FIG. 2c

FIG. 3

| F41 | F42 | | | | | | |
|---|---|---|---|---|---|---|---|
| | P1 | P2 | P3 | P4 | P5 | P6 | P7 |
| 1 | O | O | O | O | O | O | O |
| 2 | HZ | HZ | O | 1 | O | HZ | HZ |
| 3 | HZ | O | O | HZ | HZ | HZ | HZ |

FIG. 4

FIG. 5

| F 61 | F 62 | | | | | | |
|---|---|---|---|---|---|---|---|
| | P1 | P2 | P3 | P4 | P5 | P6 | P7 |
| 1 | O | O | O | O | O | O | O |
| 2 | HZ | HZ | HZ | HZ | HZ | 1 | O |
| 3 | HZ | O | HZ | HZ | HZ | O | O |
| 4 | O | O | HZ | HZ | HZ | HZ | HZ |

FIG. 6

FIG. 7

FIG. 8

FIG. 9

| F101 | F102 | | | | | | |
|---|---|---|---|---|---|---|---|
| | P1 | P2 | P3 | P4 | P5 | P6 | P7 |
| 1 | O | O | O | O | O | O | O |
| 2 | HZ | HZ | HZ | 1 | O | HZ | HZ |
| 3 | HZ | O | HZ | O | O | HZ | HZ |
| 4 | O | O | HZ | HZ | HZ | HZ | HZ |

FIG. 10

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/174129 A1 (HAIDER ALBIN [US]) 11 August 2005 (2005-08-11) * paragraphs [0003], [0020] - paragraph [0029]; figures 1-3 * * paragraphs [0037], [0049] - paragraphs [0053], [0060], [0061], [0063] * ----- | 1-4,6-15 | INV. G01R19/00 G01D5/00 ADD. G01R19/25 |
| X | DE 10 2012 207430 A1 (BOSCH GMBH ROBERT [DE]) 7 November 2013 (2013-11-07) * paragraph [0019] - paragraph [0034]; figures 1,2 * ----- | 1-3,5,7, 11 | |
| X | US 2007/176609 A1 (ELY DAVID [GB] ET AL) 2 August 2007 (2007-08-02) * abstract; figures 1,2a,6 * ----- | 1,11 | |
| A | US 2007/046299 A1 (HARGREAVES KIRK [US] ET AL) 1 March 2007 (2007-03-01) * the whole document * ----- | 1-15 | |

TECHNICAL FIELDS
SEARCHED (IPC)

G01R
G01D

The present search report has been drawn up for all claims

| Place of search | Date of completion of the search | Examiner |
|---|---|---|
| Munich | 22 March 2016 | Hof, Klaus-Dieter |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...............................................................................
& : member of the same patent family, corresponding
document

EPO FORM 1503 03.82 (P04C01)

**EP 3 018 484 A1**

## ANNEX TO THE EUROPEAN SEARCH REPORT
## ON EUROPEAN PATENT APPLICATION NO.

EP 15 38 2518

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2016

| Patent document cited in search report | Publication date | Patent family member(s) | Publication date |
|---|---|---|---|
| US 2005174129 A1 | 11-08-2005 | AT 398772 T <br> DE 102004006020 A1 <br> EP 1574847 A2 <br> US 2005174129 A1 | 15-07-2008 <br> 25-08-2005 <br> 14-09-2005 <br> 11-08-2005 |
| DE 102012207430 A1 | 07-11-2013 | CN 104272097 A <br> DE 102012207430 A1 <br> EP 2844989 A1 <br> KR 20150007295 A <br> US 2015107337 A1 <br> WO 2013164152 A1 | 07-01-2015 <br> 07-11-2013 <br> 11-03-2015 <br> 20-01-2015 <br> 23-04-2015 <br> 07-11-2013 |
| US 2007176609 A1 | 02-08-2007 | NONE | |
| US 2007046299 A1 | 01-03-2007 | US 2007046299 A1 <br> US 2008048679 A1 <br> US 2008048680 A1 <br> US 2009039902 A1 <br> US 2010148806 A1 | 01-03-2007 <br> 28-02-2008 <br> 28-02-2008 <br> 12-02-2009 <br> 17-06-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3130578 A
- EP 1397654 A
- US 20130249574 A
- US 2932970 A
- US 20130271158 A
- US 844125282 B
- DE 102006032266 A1
- DE 60218016 D1
- DE 102009032664 A1